(19) Europäisches Patentamt

European Patent Office

Office européen des brevets

(11) **EP 1 438 628 B1**

(12) **EUROPÄISCHE PATENTSCHRIFT**

(45) Veröffentlichungstag und Bekanntmachung des Hinweises auf die Patenterteilung:
**14.06.2006 Patentblatt 2006/24**

(21) Anmeldenummer: **02800106.3**

(22) Anmeldetag: **21.09.2002**

(51) Int Cl.:
***G02B 27/48*** (2006.01)

(86) Internationale Anmeldenummer:
**PCT/EP2002/010626**

(87) Internationale Veröffentlichungsnummer:
**WO 2003/029873 (10.04.2003 Gazette 2003/15)**

(54) **VERFAHREN UND VORRICHTUNG ZUR VERMINDERUNG VON SPECKLE IN EINEM OPTISCHEN SYSTEM**

METHOD AND DEVICE FOR REDUCING SPECKLE IN AN OPTICAL SYSTEM

PROCEDE ET DISPOSITIF DE REDUCTION DE SPECKLE DANS UN SYSTEME OPTIQUE

(84) Benannte Vertragsstaaten:
**AT BE BG CH CY CZ DE DK EE ES FI FR GB GR IE IT LI LU MC NL PT SE SK TR**

(30) Priorität: **28.09.2001 DE 10148170**

(43) Veröffentlichungstag der Anmeldung:
**21.07.2004 Patentblatt 2004/30**

(73) Patentinhaber: **CARL ZEISS JENA GmbH**
**07745 Jena (DE)**

(72) Erfinder:
  • **BRUNNER, Robert**
    **07743 Jena (DE)**
  • **BURKHARDT, Matthias**
    **07768 Eichenberg (DE)**
  • **ERDMANN, Lars**
    **99880 Hörselgau (DE)**
  • **MENCK, Alexander**
    **07743 Jena (DE)**

(74) Vertreter: **Geyer, Fehners & Partner**
**Patentanwälte**
**Sellierstrasse 1**
**07745 Jena (DE)**

(56) Entgegenhaltungen:
**WO-A-01/35451          DE-A- 19 645 978**
**DE-C- 19 501 525        US-A- 6 154 259**
**US-B1- 6 191 887**

  • **LULLI A ET AL: "Contrast variations in white-light speckle interferometry with application to 3D profilometry" OPTICS COMMUNICATIONS, NORTH-HOLLAND PUBLISHING CO. AMSTERDAM, NL, Bd. 124, Nr. 5, 15. März 1996 (1996-03-15), Seiten 550-557, XP004021721 ISSN: 0030-4018**

## Beschreibung

### Gebiet der Erfindung

Die Erfindung bezieht sich auf ein Verfahren zur Verminderung von Speckle in einem optischen System durch Verringerung der zeitlichen Kohärenz eines Lichtstrahlenbündels. Weiterhin bezieht sich die Erfindung auf eine entsprechende Vorrichtung, die zur Ausführung des Verfahrens dient.

### Stand der Technik

Bei der Verwendung von kohärenten Lichtquellen in optischen Systemen treten infolge von Interferenzerscheinungen oder auch niederfrequenten Amplitudenmodulationen Speckle auf, die sich als fleckenartige Leuchtdichteschwankungen störend bemerkbar machen.

Aus dem Stand der Technik sind bereits vielfältige Verfahren und Vorrichtungen zur Verminderung der Speckle bekannt, die sich in drei Kategorien einteilen lassen. Eine erste Möglichkeit besteht in der Verringerung der zeitlichen Kohärenz des Lichts, eine weitere in der Verringerung der räumlichen Kohärenz und eine dritte in einer schnellen Bewegung der Speckle, so daß diese durch das menschliche Auge oder eine entsprechende Empfangseinrichtung nicht mehr wahrnehmbar sind.

Ein Verfahren der eingangs genannten Art, das auf die Verminderung der zeitlichen Kohärenz abstellt, wird beispielsweise in der DE 195 01 525 C1 beschrieben. Neben der Möglichkeit, mikrostrukturierte Phasenplatten einzusetzen, durch welche das Lichtstrahlenbündel zum Zweck der Verminderung der zeitlichen Kohärenz hindurchtritt, wird hier weiterhin auch die Möglichkeit offenbart, eine solche Phasenplatte mit einer phasenverschiebenden Oberflächenstruktur reflektierend auszubilden. Im erstgenannten Fall ergibt sich aufgrund des Durchtritts durch ein Medium mit einer hohen Dichte eine gewisse Schwächung der Intensität. Überdies können über die Aufbrechung der Kohärenz hinausgehende Veränderungen der optischen Eigenschaften des Beleuchtungslichts auftreten. Im Falle der reflektierenden Phasenplatte ergibt sich zwangsläufig eine Umlenkung des Lichtstrahlenbündels.

Eine weitere Möglichkeit zur Verminderung von Speckle unter Verwendung reflektierender Oberflächen wird in der WO 97/02507 A1 beschrieben. Die dort vorgeschlagene Lösung umfaßt einen Drehspiegel, der von einem konischen Reflektor umgeben ist. Infolge der Rotation des Drehspiegels streicht das Lichtstrahlenbündel über eine Mantelfläche des konischen Reflektors, so daß für eine Umdrehung des Drehspiegels eine schnelle Bewegung bzw. eine Mischung der Speckle erfolgt, wodurch diese nicht mehr wahrgenommen werden können. Eine Mikrostrukturierung des Drehspiegels oder des konischen Reflektors ist in diesem Fall nicht vorgesehen.

Zur Verminderung von Speckle ist es weiterhin aus der WO 01/35451 A1 bekannt, ein Lichtstrahlenbündel mittels einer Vielzahl von in den Beleuchtungsstrahlengang eingekoppelten Einzelreflektoren in einzelne Teilstrahlenbündeln mit unterschiedlicher optischer Weglänge aufzuspalten, wobei die Weglängenunterschiede größer als die zeitliche Kohärenzlänge sind. Bei der in der WO 01 /35451 A1 vorgeschlagenen Lösung ergibt sich wiederum eine Ablenkung des Lichtstrahlenbündels. Dabei wird jedoch jeder Abschnitt des Lichtstrahlenbündels lediglich ein einziges Mal reflektiert. Eine Mikrostrukturierung der Einzelreflektoren ist hier nicht vorgesehen.

Aufgrund der Vielzahl der im Vergleich zu der Wellenlänge verhältnismäßig großen Einzelreflektoren können Abschattungseffekte auftreten, welche die Leuchtintensität tendenziell vermindern. Zudem tritt eine deutliche Strahlaufweitung auf, die durch geeignete Linsen kompensiert werden muß.

### Beschreibung der Erfindung

Davon ausgehend liegt der Erfindung die Aufgabe zugrunde, eine weitere Möglichkeit zur Verminderung von Speckle zu schaffen, ohne dabei die Intensität des Lichtstrahlenbündels wesentlich zu schwächen.

Erfindungsgemäß wird bei einem Verfahren der eingangs genannten Art das Lichtstrahlenbündel mit wenigstens zwei reflektierenden Oberflächen in Wechselwirkung gebracht, von denen jede eine phasenverschiebende Mikrostrukturierung aufweist, über die das Lichtstrahlenbündel in Teilstrahlenbündel aufgespalten wird, wobei die optischen Weglängen zwischen den reflektierenden Oberflächen sich um mehr als die zeitliche Kohärenzlänge unterscheiden.

Aufgrund der Reflexion des Lichtstrahlenbündels an wenigstens zwei Oberflächen können die phasenverschiebenden Mikrostrukturierungen in ihren Abmessungen verhältnismäßig klein gewählt werden, wodurch sich Abschattungseffekte weniger stark auswirken und sich somit die Intensität des Lichtstrahlenbündels nur in geringem Maße abschwächen kann. Wegen der zwischen den reflektierenden Oberflächen bewirkten Phasenverschiebung zwischen den Teilstrahlenbündeln wird die Kohärenz des Lichtstrahlenbündels aufgebrochen und damit dessen Interferenzfähigkeit, die eine Ursache für die Bildung von Speckle ist, vermindert.

In einer vorteilhaften Ausgestaltung des Verfahrens wird das Lichtstrahlenbündel mehrfach zwischen den reflektierenden Oberflächen hin- und herreflektiert. Die Strukturtiefen an den reflektierenden Oberflächen lassen sich so auf ein Minimum verringern.

Im Hinblick auf eine kompakte Bauweise sowie die weitere Verminderung von Abschattungs- und Versatzeffekten ist es vorteilhaft, den Einfallswinkel des Lichtstrahlenbündels zu der Flächennormalen der reflektierenden Oberflächen so klein wie möglich zu halten. In vorteilhafter Ausgestaltung des erfindungsgemäßen Verfahrens sind die reflektierenden Oberflächen einander parallel gegenüberliegend angeordnet. Durch die Einkopplung des Beleuchtungsstrahlengangs in einem Winkelbereich zwischen 0° und 15°, vorzugsweise zwischen 0° und 10° zur Flächennormalen der beiden reflektierenden Oberflächen läßt sich eine hohe Leuchtdichte des Lichtstrahlenbündels auch nach mehreren Reflexionen gewährleisten.

Eine weitere Verminderung der Interferenzfähigkeit wird vorzugsweise dadurch erreicht, daß die laterale Ausdehnung der Teilstrahlenbündel nach den kaskadenartigen Reflexionen an den reflektierenden Oberflächen kleiner als die räumliche Kohärenzlänge ist.

In einer weiteren vorteilhaften Ausgestaltung des Verfahrens können die reflektierenden Oberflächen relativ zueinander bewegt werden. Die Relativbewegung kann dabei sowohl durch eine Verschiebung in der Ebene der Mikrostrukturierung als auch durch eine Veränderung des Abstands zwischen den reflektierenden Oberflächen realisiert werden. Hierdurch wird eine weitere Verminderung der Interferenzfähigkeit des Lichtstrahlenbündels erzielt.

Zur Lösung der oben genannten Aufgabe wird weiterhin eine Vorrichtung zur Verminderung von Speckle in einem optischen System vorgeschlagen, bei der zwei mit phasenverschiebender Mikrostrukturierung versehene Reflektoren einander parallel gegenüberstehend angeordnet sind und die Mikrostrukturierung derart ausgebildet ist, daß das Lichtstrahlenbündel bei aufeinander folgenden Reflexionen an den Reflektoren in Teilstrahlenbündel aufgespalten wird, deren optische Wege sich um mehr als die zeitliche Kohärenzlänge unterscheiden.

Die erfindungsgemäße Vorrichtung weist die bereits oben erläuterten Vorteile auf. Durch Mehrfachreflexion des Lichtstrahlenbündels an den Reflektoren wird eine Kaskadierung erreicht, die neben einer kompakten Bauweise bei geringen Strukturtiefen auf den Reflektoren eine ausreichend hohe optische Wegdifferenzen erlaubt. In einer bevorzugten Gestaltungsvariante sind zwei Reflektoren vorgesehen, die parallel zueinander angeordnet sind.

Vorzugsweise wird das Lichtstrahlenbündel in einem Winkelbereich zwischen 0° und 15°, bevorzugt zwischen 0° und 10° zu der Flächennormalen der Reflektoren zwischen diese eingekoppelt. Wie bereits oben erwähnt, können so Abschattungs- und Versatzeffekte gering gehalten werden. Damit bleibt die Intensität des Lichtstrahlenbündels weitestgehend erhalten.

In einer vorteilhaften Ausgestaltung der Vorrichtung wird die Mikrostrukturierung durch Vertiefungen gebildet, deren Tiefe im Bereich von $0,1\ \mu m$ bis $1000\ \mu m$ liegt. Mit einer derartigen Mikrostrukturierung versehene Reflektoren lassen sich beispielsweise durch anisotrope Trockenätzverfahren an Silizium herstellen. Dies ist beispielsweise in der US 5,501,893 A beschrieben.

Beispielsweise können die Strukturen in Abhängigkeit vom Abstand der Reflektoren in einem photolithographischen Schritt definiert werden. Die Siliziumoberflächen werden dann entsprechend der Wellenlänge des Lichtstrahlenbündels metallisch oder mit einer dielektrischen Schicht verspiegelt. Bei einer minimalen Anzahl von Reflexionen an den beiden Reflektoren beträgt die Tiefe bzw. Stufenhöhe der Mikrostrukturierung mindestens die Hälfte der zeitlichen Kohärenzlänge $L_{coh}$. Werden für das Lichtstrahlenbündel mehr als eine Reflexion je Reflektor vorgesehen, kann die Tiefe bzw. Stufenhöhe auch kleiner gewählt werden. Im erstgenannten Fall wird jedoch stets gewährleistet, daß eine ausreichende Weglängendifferenz bzw. Phasenverschiebung zwischen den Teilstrahlenbündeln des Lichtstrahlenbündels erhalten wird.

In einer weiteren vorteilhaften Ausgestaltung der Vorrichtung erstreckt sich die Mikrostrukturierung auf den reflektierenden Oberflächen über jeweils gleiche Flächenabschnitte mit einer maximalen Seitenlänge a, für die gilt

$$a < (n\text{-}1) \cdot \Delta x,$$

wobei n die Anzahl der Reflexionen des Lichtstrahlenbündels an den Reflektoren und $\Delta x$ die räumliche Kohärenzlänge bedeuten. Auf diese Weise wird zusätzlich die räumliche Kohärenz des Lichtstrahlenbündels und damit dessen Interferenzfähigkeit zusätzlich verringert.

Zur weiteren Verminderung von Speckle kann überdies eine Antriebseinrichtung zur Erzeugung einer oszillierenden Relativbewegung zwischen den Reflektoren vorgesehen werden. Diese können sowohl in der Erstreckungsebene der reflektierenden Flächen als auch senkrecht dazu zu Schwingungen angeregt werden, woraus eine Mischung auftretender Speckle resultiert, die dann nicht mehr optisch wahrnehmbar in Erscheinung treten. Frequenzen in der Größenordnung von 10 Hz haben sich hierfür in den meisten Fällen als ausreichend erwiesen. Allerdings lassen sich mit mikro-elektro-mechani-schen Systemen (MEMS) auch Frequenzen von mehreren 100 kHz realisieren.

Weiterhin ist es möglich, die reflektierenden Oberflächen bei beiden Reflektoren lediglich abschnittsweise mit einer Mikrostrukturierung zu versehen, so daß unstrukturierte reflektierende Flächenabschnitte mit strukturierten reflektierenden Flächenabschnitten abwechseln. Die unstrukturierten und strukturierten Flächenabschnitte sind dabei derart angeordnet, daß ein durch die Vorrichtung hindurchtretendes Lichtstrahlenbündel zwischen den strukturierten Flächenabschnitten hin- und herreflektiert wird. Der Herstellungs- bzw. Bearbeitungsaufwand für die Reflektoren kann so gering gehalten werden.

Vorzugsweise werden auch die unstrukturierten Flächenabschnitte derart angeordnet, daß in einer ausgewählten Stellung der Reflektoren ein durch die Vorrichtung hindurchtretendes Lichtstrahlenbündel ausschließlich zwischen unstrukturierten Flächenabschnitten hin- und herreflektiert wird. Dies kann durch einen Umschaltmechanismus ermöglicht werden, so daß je nach Bedarf auf einfache Weise zwischen einem Lichtstrahlenbündel mit hoher Kohärenz und geringer Kohärenz umgeschaltet werden kann.

Da das erfindungsgemäße Verfahren sowie auch die erfindungsgemäße Vorrichtung ohne refraktive oder diffraktive optische Elementen auskommen, vielmehr ausschließlich mit reflektiven Elementen arbeiten, ist die Erfindung auch für Systeme anwendbar, die im tiefen UV-Bereich (DUV) betrieben werden.

## Kurze Beschreibung der Zeichnungen

Nachfolgend wird die Erfindung anhand eines bevorzugten Ausführungsbeispiels näher erläutert. Die zugehörigen Zeichnungen zeigen in:

Fig.1 eine schematische Ansicht einer Vorrichtung nach der Erfindung mit zwei einander parallel gegenüberliegenden Reflektoren,

Fig.2 Ausschnitte einer Mikrostrukturierung an der Oberfläche der Reflektoren aus Fig.1 sowie der zugehörigen Veränderung der Wellenfront eines Lichtstrahlenbündels,

Fig.3 eine Detailansicht eines Ausschnittes aus der Oberfläche eines Reflektors im Bereich der Mikrostrukturierung, und in

Fig.4 eine schematische Ansicht der Wellenfront eines Lichtstrahlenbündels (a) vor der erfindungsgemäßen Vorrichtung und (b) hinter der erfindungsgemäßen Vorrichtung.

## Ausführliche Beschreibung der Zeichnungen

Das Ausführungsbeispiel zeigt in schematischer Darstellung eine Vorrichtung zur Verminderung von Speckle, die zum Einsatz in optischen Systemen mit kohärenten Lichtquellen, insbesondere Laserlichtquellen, geeignet ist.

Die Vorrichtung umfaßt zwei Reflektoren 1 und 2, die an ihren reflektierenden Oberflächen jeweils eine phasenverschiebende Mikrostrukturierung aufweisen. In dem hier dargestellten Ausführungsbeispiel sind die beiden Reflektoren 1 und 2 mit ihren reflektierenden Oberflächen einander parallel gegenüberliegend angeordnet. Zur Verminderung insbesondere der zeitlichen Kohärenz wird ein Lichtstrahlenbündel derart zwischen den Reflektoren 1 und 2 eingekoppelt, daß das Lichtstrahlenbündel mit jeder reflektierenden Oberfläche der Reflektoren 1 und 2 wenigstens einmal in Wechselwirkung steht.

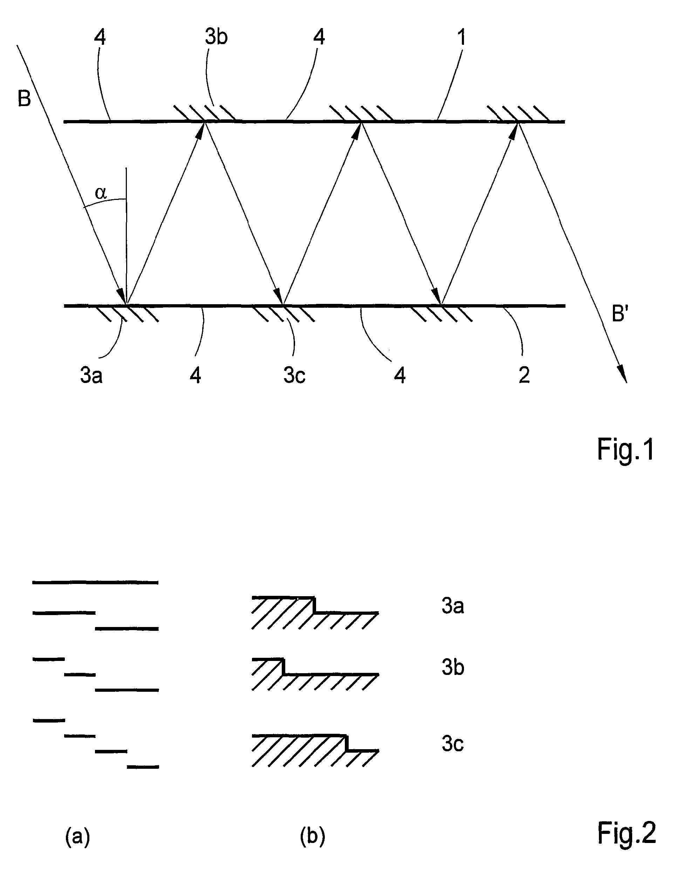

Bei dem in Fig.1 gezeigten Beispiel wird das eintretende Lichtstrahlenbündel B mehrfach zwischen den reflektierenden Oberflächen der Reflektoren 1 und 2 hin- und hergeworfen, bevor das Lichtstrahlenbündel B' verändert aus der Vorrichtung austritt.

Die Mikrostruktur auf den reflektierenden Oberflächen der Reflektoren 1 und 2 ist derart ausgebildet, daß das Lichtstrahlenbündel B in Teilstrahlenbündel aufgespalten wird. Die lokalen optischen Weglängen dieser Teilstrahlenbündel innerhalb der Vorrichtung unterscheiden sich voneinander, wobei Weglängendifferenzen auftreten, welche größer als die zeitliche Kohärenzlänge $L_{coh}$ sind. Durch die damit verbundene Verminderung der Kohärenz bzw. Interferenzfähigkeit des Lichtstrahlenbündels B' am austrittseitigen Ende der Vorrichtung werden Speckle reduziert, und zwar vorzugsweise auf ein solches Maß, daß deren Wahrnehmung durch einen Betrachter oder eine optoelektronische Empfangsvorrichtung nicht mehr möglich ist.

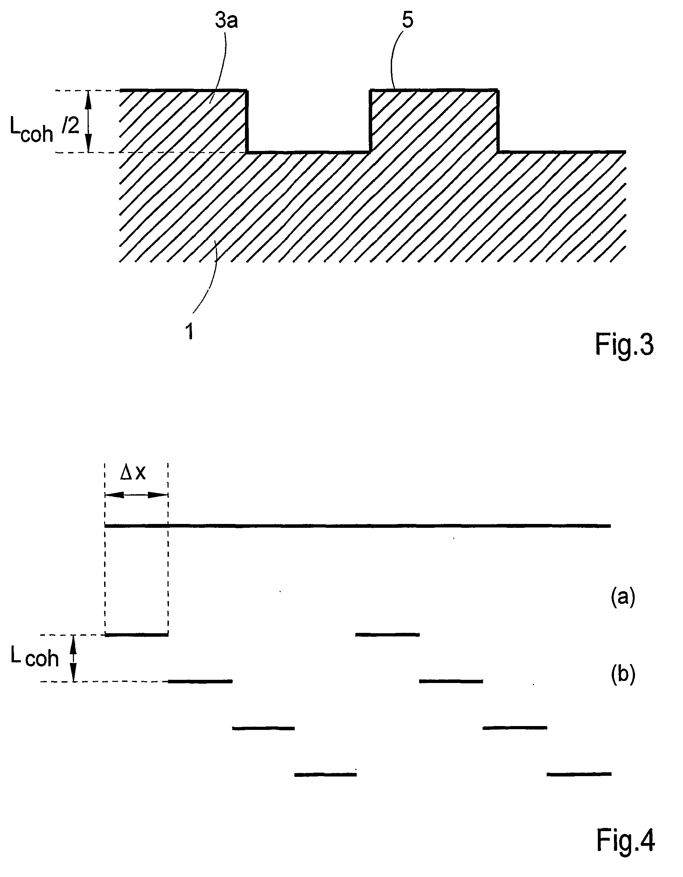

Die hierfür verwendeten Mikrostrukturen an den Oberflächen der Reflektoren 1 und 2 sind in den Fig. 2 und Fig.3 beispielhaft dargestellt. Zum Zwecke der Erzeugung lokaler optischer Wegdifferenzen sind an den reflektierenden Oberflächen Vertiefungen vorgesehen, die hier etwa stufenförmig ausgebildet sind.

Wie Fig.3 zeigt, besitzen die Vertiefungen bzw. Stufen eine Höhe in der Größenordnung der halben zeitlichen Kohärenzlänge $L_{coh}$. Trifft ein kollimiertes Lichtstrahlenbündel B auf eine solche Stufe, so ergibt sich an einer Kante der Stufe eine Aufspaltung in zwei Teilstrahlenbündel, woraus unterschiedliche optische Weglängen für die Teilstrahlenbündel zugleich mit einer Phasenverschiebung erhalten werden.

Bei mehrfachen Reflexionen an den reflektierenden Flächenabschnitten 3a, 3b und 3c, die ausschnittsweise im Detail in Fig.2b vergrößert dargestellt sind, kann das Lichtstrahlenbündel B in eine Vielzahl von Teilstrahlenbündel aufgespalten werden. Die laterale Ausdehnung der Mikrostrukturen bzw. von Teilbereichen der Mikrostrukturen ist derart gewählt, daß auch die räumliche Kohärenz aufgehoben wird, wie dies in Fig.2a für eine Wellenfront dargestellt ist, die aufeinanderfolgend an den Flächenabschnitten 3a, 3b und 3c reflektiert worden ist.

Das Aufbrechen der räumlichen Kohärenz $\Delta x$ ist durch die Auflösung der Wellenfront quer zu deren Ausbreitungsrichtung gegeben. Der Unterschied einer Wellenfront zwischen dem eintritt- und dem austrittseitigen Ende der Vorrichtung ist in Fig.4 dargestellt, wobei die gerade Linie bei (a) eine Wellenfront von kohärentem Licht am eintrittseitigen Ende darstellt.

Aufgrund der Kaskadierung der Reflexionen und wie auch durch eine geeignete Wahl der Mikrostrukturierung, insbesondere durch die Ausbildung und Anordnung der Ränder der Vertiefungen, wird eine gute Durchmischung der Phasenraumzellen des Lichtstrahlenbündels B erzielt, nämlich indem die Phasenraumzellen räumlich, insbesondere auch in Strahlausbreitungsrichtung, versetzt werden.

Die Kaskadierung besitzt überdies den Vorteil, daß hohe Wegdifferenzen zwischen diesen Phasenraumzellen bei geringen Strukturtiefen an den Reflektoren 1 und 2 erzielt werden können. Bei einer Mehrfachreflexion kann die gewünschte Weglängendifferenz auch kumulativ durch Vertiefungen bzw. Stufen an mehreren reflektierenden Flächenabschnitten 3a, 3b und 3c erhalten werden, so daß die Tiefe der Strukturen auch kleiner als in Fig.3 gezeigt gewählt werden kann.

Zur Vermeidung von Abschattungs- und Versatzeffekten, welche zu Lichtverlusten führen, wird das Lichtstrahlenbündel B unter einem möglichst kleinen Einfallswinkel $\alpha$ zur Flächennormalen der Reflektoren 1 und 2 eingekoppelt. Vorzugsweise liegt der Einfallswinkel $\alpha$ im Bereich zwischen 0° und 15°, besonders bevorzugt zwischen 0° und 10°.

Die Mikrostruktur läßt sich beispielsweise mittels eines anisotropen Trockenätzverfahrens in Silizium herstellen, wie dies beispielsweise in der US 5,501,893 A1 offenbart ist. Damit sind Vertiefungen bzw. Stufen mit einer lateralen Ausdehnung von 0,1 $\mu$m bis 1000 $\mu$m bei Aspektverhältnissen (Breite : Tiefe) von 1:50 herstellbar. Die Strukturierung sowie der Abstand der Reflektoren 1 und 2 können in einem fotolithographischen Schritt definiert werden. Zur Erhöhung der Reflektivität werden die Oberflächen entsprechend der Wellenlänge des Beleuchtungslichts metallisch oder mit einer dielektrischen Schicht 5 verspiegelt.

Prinzipiell ist es möglich, die gesamte reflektierende Oberfläche beider Reflektoren 1, 2 durchgehend mit einer einheitlichen Mikrostrukturierung zu versehen. In dem hier dargestellten Ausführungsbeispiel ist die Mikrostrukturierung jedoch lediglich abschnittsweise vorgenommen, so daß auf jedem Reflektor 1 bzw. 2 sowohl strukturierte reflektierende Flächenabschnitte 3a, 3b und 3c wie auch unstrukturierte reflektierende Flächenabschnitte 4 vorhanden sind. Die Positionierung der Flächenabschnitte erfolgt dabei so, daß ein durch die Vorrichtung hindurchtretendes Lichtstrahlenbündel B zwischen den strukturierten Flächenabschnitten 3a, 3b und 3c hin- und herreflektiert wird. Gleiches gilt vorzugsweise auch für die Anordnung der unstrukturierten Flächenabschnitte 4 bezogen auf eine andere Eintrittsposition des Lichtstrahlenbündels B. Durch jeweilige Verschiebung der Reflektoren 1, 2 relativ zu dem einfallenden Lichtstrahlenbündel B wird so eine Möglichkeit geschaffen, wahlweise zwischen kohärentem Licht und Licht mit verringerter Kohärenz am austrittseitigen Ende umzuschalten.

Bei entsprechender Ausdehnung der strukturierten Flächenabschnitte 3a, 3b und 3c kann überdies durch eine Bewegung der Vorrichtung eine weitere Verminderung der Speckle erzielt werden. Denkbar ist auch eine Relativverschiebung zwischen den Reflektoren 1 und 2, die sowohl in der Ebene der einzelnen Reflektoren als auch senkrecht hierzu erfolgen kann. Mit Anregungsfrequenzen in der Größenordnung von 10 Hz können so Speckle für das menschliche Auge unsichtbar gemacht werden.

Das Ausführungsbeispiel wurde anhand zweier parallel zueinander angeordneter Reflektoren 1 und 2 beschrieben. Es ist jedoch auch möglich eine größere Anzahl von Reflektoren bzw. von reflektierenden Oberflächen einzusetzen. Weiterhin können die Reflektoren bzw. Oberflächen in Abweichung von der Parallelanordnung unter einem anderen Winkel zueinander angestellt werden, solange eine Wechselwirkung des Lichtstrahlenbündels B noch gewährleistet ist.

Da die erläuterte Vorrichtung ausschließlich reflektive Elemente verwendet, ist diese auch gut für energiereichere Strahlung, insbesondere auch im DUV-Bereich, einsetzbar.

Beispielsweise kann die Vorrichtung in einem DUV-Beleuch-tungssystem vor einer Streuscheibe oder einem Mikrolinsenarray zur Einstellung eines gewünschten Lichtleitwertes angeordnet werden. In einer günstigen Ausführungsvariante ergibt sich somit eine Beleuchtungsvorrichtung, welche eine definiert streuende reflektive Mikrospiegelstruktur als letztes Element im Strahlengang verwendet.

Die Erfindung beschränkt sich nicht auf die bisher beschriebenen Ausführungsbeispiele. So ist es zum Beispiel weiterhin denkbar, in der erfindungsgemäßen Anordnung sich gegenüberstehende Reflektorflächen vorzusehen, die zweidimensional strukturiert sind, wodurch bei der Mehrfachreflexion die räumliche Kohärenz in beiden lateralen Richtungen gleichzeitig vermindert wird.

## Patentansprüche

**1.** Verfahren zur Verminderung von Speckle in einem optischen System durch Verringerung der räumlichen Kohärenz eines Lichtstrahlenbündels, **dadurch gekennzeichnet, daß** das Lichtstrahlenbündel mit wenigstens zwei reflektierenden Oberflächen in Wechselwirkung gebracht wird, von denen jede eine phasenverschiebende Mikrostrukturierung aufweist, über die das Lichtstrahlenbündel in Teilstrahlenbündel aufgespalten wird, wobei die optischen Weglängen zwischen den reflektierenden Oberflächen sich um mehr als die zeitliche Kohärenzlänge unterscheiden.

**2.** Verfahren nach Anspruch 1, **dadurch gekennzeichnet, daß** das Lichtstrahlenbündel mehrfach zwischen zwei reflektierenden Oberflächen hin und her reflektiert wird.

**3.** Verfahren nach Anspruch 1 oder 2, **dadurch gekennzeichnet, daß** die reflektierenden Oberflächen einander parallel gegenüberliegen und das Lichtstrahlenbündel so zwischen diese eingekoppelt wird, daß das Lichtstrahlenbündel mit den Flächennormalen auf den reflektierenden Oberflächen einen Winkel im Bereich zwischen 0° und 15°, bevorzugt zwischen 0° und 10°, einschließt.

**4.** Verfahren nach einem der Ansprüche 1 bis 3, **dadurch gekennzeichnet, daß** die laterale Ausdehnung der Teilstrahlenbündel nach erfolgter Wechselwirkung des Lichtstrahlenbündels mit den reflektierenden Oberflächen kleiner als die räumliche Kohärenzlänge ist.

5. Verfahren nach einem der Ansprüche 1 bis 4, **dadurch gekennzeichnet, daß** die reflektierenden Oberflächen relativ zueinander bewegt werden.

6. Vorrichtung zur Verminderung von Speckle in einem optischen System durch Verringerung der zeitlichen Kohärenz eines Lichtstrahlenbündels mittels phasenverschiebender Mikrostrukturierung auf reflektierenden Oberflächen, **dadurch gekennzeichnet, daß** zwei mit phasenverschiebender Mikrostrukturierung versehene Reflektoren (1, 2) einander parallel gegenüberstehend angeordnet sind und die Mikrostrukturierung derart ausgebildet ist, daß das Lichtstrahlenbündel bei aufeinander folgenden Reflexionen an den Reflektoren (1, 2) in Teilstrahlenbündel aufgespalten wird, deren optische Wege sich um mehr als die zeitliche Kohärenzlänge unterscheiden.

7. Vorrichtung nach Anspruch 6, **dadurch gekennzeichnet, daß** das Lichtstrahlenbündel mit den Flächennormalen auf den reflektierenden Oberflächen einen Winkel im Bereich zwischen 0° und 15°, bevorzugt zwischen 0° und 10°, einschließt.

8. Vorrichtung nach Anspruch 6 oder 7, **dadurch gekennzeichnet, daß** die Mikrostrukturierung durch Vertiefungen gebildet ist, deren Tiefe im Bereich von 0,1 μm bis 1000 μm liegt.

9. Vorrichtung nach einem der Ansprüche 6 bis 8, **dadurch gekennzeichnet, daß** sich die Mikrostrukturierung auf den reflektierenden Oberflächen über jeweils gleiche Flächenabschnitte mit einer maximalen Seitenlänge a erstrecken, wobei gilt

$$a < (n-1)^* \Delta x,$$

mit n der Anzahl der Reflexionen des Lichtstrahlenbündels zwischen den Reflektoren (1, 2) und Δx der räumlichen Kohärenzlänge.

10. Vorrichtung nach einem der Ansprüche 6 bis 9, **dadurch gekennzeichnet, daß** die Reflektoren (1, 2) mit einer Antriebseinrichtung zur Erzeugung einer oszillierenden Bewegung relativ zueinander gekoppelt sind.

11. Vorrichtung nach einem der Ansprüche 6 bis 1 0, **dadurch gekennzeichnet, daß** die reflektierenden Oberflächen der Reflektoren (1, 2) lediglich abschnittsweise mit einer Mikrostrukturierung versehen sind und unstrukturierte reflektierende Flächenabschnitte (4) mit strukturierten reflektierenden Flächenabschnitten (3a, 3b, 3c) abwechselnd angeordnet sind.

12. Vorrichtung nach Anspruch 11, **dadurch gekennzeichnet, daß** die unstrukturierten Flächenabschnitte (4) und die strukturierten Flächenabschnitte (3a, 3b, 3c) so angeordnet sind, daß ein durch die Vorrichtung hindurchtretendes Lichtstrahlenbündel ausschließlich zwischen den strukturierten Flächenabschnitten (3a, 3b, 3c) hin- und her reflektiert wird.

13. Vorrichtung nach Anspruch 11 oder 12, **dadurch gekennzeichnet, daß** die Reflektoren (1, 2) zwecks Positionsänderung mit einem Verschiebemechanismus gekoppelt, wobei in einer ersten Position ein durch die Vorrichtung hindurchtretendes Lichtstrahlenbündel ausschließlich zwischen den strukturierten Flächenabschnitten (3a, 3b, 3c) und in einer zweiten Position ein durch die Vorrichtung hindurchtretendes Lichtstrahlenbündel ausschließlich zwischen unstrukturierten Flächenabschnitten (4) hin- und her reflektiert wird.

## Claims

1. Method of reducing speckle in an optical system by reduction of the spatial coherence of a light beam, **characterised in that** the light beam is made to interact with at least two reflecting surfaces, each of which has a phase-shifting microstructuring by means of which the light beam is divided into sub-beams, wherein the optical paths between the reflecting surfaces differ by more than the temporal coherence length.

2. Method as claimed in Claim 1, **characterised in that** the light beam is reflected to and fro a number of times between two reflecting surfaces.

3. Method as claimed in Claim 1 or 2, **characterised in that** the reflecting surfaces lie parallel opposite one another and the light beam is input between them in such a way that on the reflecting surfaces the light beam encloses an angle in the range between 0° and 15°, preferably between 0° and 10°.

4. Method as claimed in any one of Claims 1 to 3, **characterised in that** the lateral extent of the sub-beam after interaction of the light beam with the reflecting surfaces is smaller than the spatial coherence length.

5. Method as claimed in any one of Claims 1 to 4, **characterised in that** the reflecting surfaces are moved relative to one another.

6. Apparatus for reducing speckle in an optical system by reduction of the temporal coherence of a light beam by means of phase-shifting microstructuring on reflecting surfaces, **characterised in that** two reflectors (1, 2) provided with phase-shifting microstructuring are disposed parallel opposite one another and the microstructuring is constructed in such a way that with successive reflections on the reflectors (1, 2) the light beam is divided into sub-beams of which the optical paths differ by more than the temporal coherence length.

7. Apparatus as claimed in Claim 6, **characterised in that** the light beam encloses an angle in the range between 0° and 15°, preferably between 0° and 10°, with the surface normal on the reflecting surfaces.

8. Apparatus as claimed in Claim 6 or 7, **characterised in that** the microstructuring is formed by depressions, the depth of which is in the range from 0.1 $\mu$m to 1000 $\mu$m.

9. Apparatus as claimed in any one of Claims 6 to 8, **characterised in that** the microstructuring extends on the reflecting surfaces in each case over equal surface portions with a maximum side length a, where

$$a < (n\text{-}1)^* \, \Delta x$$

applies, n being the number of reflections of the light beam between the reflectors (1, 2) and $\Delta$x being the spatial coherence length.

10. Apparatus as claimed in any one of Claims 6 to 9, **characterised in that** the reflectors (1, 2) are coupled to a drive means for generating an oscillating motion relative to one another.

11. Apparatus as claimed in any one of Claims 6 to 10, **characterised in that** the reflecting surfaces of the reflectors (1, 2) are provided only in portions with a microstructuring and unstructured reflecting surface portions (4) are disposed so as to alternate with structured reflecting surface portions (3a, 3b, 3c).

12. Apparatus as claimed in Claim 11, **characterised in that** the unstructured surface portions (4) and the structured surface portions (3a, 3b, 3c) are disposed so that light beam passing through the apparatus is reflected to and fro exclusively between the structured surface portions (3a, 3b, 3c).

13. Apparatus as claimed in Claim 11 or 12, **characterised in that** for the purpose of changing position the reflectors (1, 2) are coupled to a shifting mechanism, wherein in a first position a light beam passing through the apparatus is reflected to and fro exclusively between the structured surface portions (3a, 3b, 3c) and in a second position a light beam passing through the apparatus is reflected to and fro exclusively between unstructured surface portions (4).

**Revendications**

1. Procédé pour réduire les petites taches dans un système optique par réduction de la cohérence dans l'espace d'un faisceau lumineux, **caractérisé en ce que** le faisceau lumineux est amené en interaction avec au moins deux surfaces réfléchissantes, dont chacune présente une microstructuration de déphasage, par laquelle le faisceau lumineux est dissocié en faisceaux lumineux partiels, les longueurs de trajet optique entre les surfaces réfléchissantes se différenciant de plus de la longueur de cohérence dans le temps.

2. Procédé selon la revendication 1, **caractérisé en ce que** le faisceau lumineux est réfléchi plusieurs fois en faisant des allers et retours entre deux surfaces réfléchissantes.

3. Procédé selon la revendication 1 ou 2, **caractérisé en ce que** les surfaces réfléchissantes se font face en parallèle et le faisceau lumineux est injecté ainsi entre ces surfaces de telle sorte que le faisceau lumineux forme avec les perpendiculaires sur les surfaces réfléchissantes un angle compris entre 0° et 15°, de préférence entre 0° et 10°.

4. Procédé selon l'une quelconque des revendications 1 à 3, **caractérisé en ce que** la dilatation latérale des faisceaux lumineux partiels est inférieure à la longueur de cohérence dans l'espace après une interaction du faisceau lumineux avec les surfaces réfléchissantes.

5. Procédé selon l'une quelconque des revendications 1 à 4, **caractérisé en ce que** les surfaces réfléchissantes sont déplacées les unes par rapport aux autres.

6. Dispositif pour éviter des petites taches dans un système optique par réduction de la cohérence dans le temps d'un faisceau lumineux au moyen d'une microstructuration de déphasage sur des surfaces réfléchissantes, **caractérisé en ce que** deux réflecteurs (1, 2) dotés d'une microstructuration de déphasage sont disposés l'un en face de l'autre en parallèle et la microstructuration est conçue de telle sorte que le faisceau lumineux est dissocié en faisceaux lumineux partiels dans le cas de réflexions consécutives sur les réflecteurs (1, 2), faisceaux dont les trajets optiques se différencient de plus de la longueur de cohérence dans le temps.

7. Dispositif selon la revendication 6, **caractérisé en ce que** le faisceau lumineux forme avec les perpendiculaires sur les surfaces réfléchissantes un angle compris dans la plage entre 0° et 15° et de préférence entre 0° et 10°.

8. Dispositif selon la revendication 6 ou 7, **caractérisé en ce que** la microstructuration est formée de cavités dont la profondeur se situe dans la plage de 0,1 $\mu$m jusqu'à 1.000 $\mu$m.

9. Dispositif selon l'une quelconque des revendications 6 ou 8, **caractérisé en ce que** les microstructurations sur les surfaces réfléchissantes s'étendent sur des sections de surface respectivement identiques avec une longueur de côté maximale a, sachant qu'on a

$$a < (n - 1)^* \; \Delta x,$$

n étant le nombre des réflexions du faisceau lumineux entre les réflecteurs (1, 2) et $\Delta x$ la longueur de cohérence dans l'espace.

10. Dispositif selon l'une quelconque des revendications 6 à 9, **caractérisé en ce que** tous les réflecteurs (1, 2) sont couplés à un dispositif d'entraînement pour générer un déplacement oscillant les uns par rapport aux autres.

11. Dispositif selon l'une quelconque des revendications 6 à 10, **caractérisé en ce que** les surfaces réfléchissantes des réflecteurs (1, 2) sont dotées seulement par endroits d'une microstructuration et des sections de surface (4) réfléchissantes et non structurées sont disposées alternativement avec des sections de surface (3a, 3b, 3c) réfléchissantes et structurées.

12. Dispositif selon la revendication 11, **caractérisé en ce que** les sections de surface (4) non structurées et les sections de surface (3a, 3b, 3c) structurées sont disposées de telle sorte qu'un faisceau lumineux passant à travers le dispositif est réfléchi en faisant des allers et retours exclusivement entre les sections de surface (3a, 3b, 3c) structurées.

13. Dispositif selon la revendication 11 ou 12, **caractérisé en ce que** les réflecteurs (1, 2) sont couplés à un mécanisme de déplacement pour la modification de position, un faisceau lumineux passant à travers le dispositif étant réfléchi dans une première position en faisant des allers et retours exclusivement entre les sections de surface (3a, 3b, 3c) structurées et un faisceau lumineux passant à travers le dispositif est réfléchi dans une seconde position en faisant des allers et retours exclusivement entre des sections de surface (4) non structurées.

Fig.1

(a)　　　　　　　　(b)　　　　　　　Fig.2

3a                5

$L_{coh}$ /2

1

Fig.3

Δx

$L_{coh}$

(a)

(b)

Fig.4